# EUROPEAN PATENT SPECIFICATION

(11) **EP 0 527 616 B1**
(45) Date of publication and mention of the grant of the patent: **09.11.1994**
(21) Application number: 92307257.3
(22) Date of filing: 07.08.1992
(51) Int. Cl.: C23F 1/04

(54) **Improvements in or relating to dies**
Verfahren zur Herstellung von Matrizen
Perfectionnement concernant la fabrication de matrices

(30) Priority: 09.08.1991 JP 200914/91
(43) Date of publication of application: 17.02.1993
(73) Proprietor: LINTEC Corporation, Tokyo (JP)
(72) Inventor: Hanada, Yozaburo, Itabashi-ku, Tokyo 173 (JP)
(74) Representative: Marsden, John Christopher

(56) References cited:
- EP-A- 0 476 664
- GB-A- 2 066 162
- JP-A-56 090 977
- US-A- 3 045 321
- US-A- 4 102 735
- PATENT ABSTRACTS OF JAPAN vol. 7, (C-0959)6 July 1992

## Description

This invention relates to a process for producing dies, more particularly to a process capable of producing dies in which the cutting portion has a sharp cutting edge and is of substantial height and sufficient width, and to novel dies obtainable by this process.

It is known to produce dies having a raised cutting portion in a particular pattern, e.g. for cutting materials such as adhesive tape to form labels or markers in this particular shape, by forming a resist on a metal plate (e.g. a steel plate such as a low carbon steel or the like, said resist corresponding to the desired cutting pattern, and subjecting the resulting plate to etching treatment. This process, however, may give rise to problems such as formation of a raised cutting portion having inadequate height and/or a dull cutting edge.

Suggestions for solving such problems include the use of two-step etching (see, for example, Japanese Patent Publication No. 10000/1977 and 27938/1982, and Japanese Patent L-O-P Publication No. 105980/1988). In such processes a resist corresponding to the desired cutting pattern is formed on a metal plate, which is thereafter subjected to a first etching treatment to form a raised portion corresponding to the cutting pattern. The resist remaining on the top of the raised portion is then removed therefrom, whereafter the plate is subjected to a second etching treatment so that a sharper edge is formed on the raised portion.

In all the above-described processes, the edges of the resist increasingly overhang the raised portion as etching progresses, this so-called burr inhibiting etching in the vicinity of the resist. However, intermediate side parts of the raised portion, e.g. its centre part, are not so inhibited and may therefore undergo excessive etching, resulting in the centre part of the raised portion being too thin, of inadequate strength and liable to break.

The present invention is based on our finding that improved dies may be obtained by a process in which at least two etching treatments are performed before the resist is finally removed, the burr of the resist resulting from the first etching treatment being removed before the second etching treatment is effected.

Thus according to one aspect of the invention we provide a process for producing a cutting die which comprises
(i) forming a resist material on a surface of a metal plate in a pattern corresponding to the shape to be cut by the die;
(ii) subjecting the resulting plate to an etching treatment such that a raised portion of metal remains where the resist material has been formed;
(iii) removing resist material which extends beyond the said raised portion;
(iv) subjecting the resulting plate to a further etching treatment; and
(v) removing the resist material from the raised portion.

By means of this process it is possible to produce dies in which the cutting portion has a sharp edge and is of substantial height and sufficient width, since the sides of the raised portion may be etched more uniformly than in previously proposed processes.

If desired, dies produced in accordance with the invention may be subjected to a further etching step after removal of the resist material in step (v), in order to produce dies having a further sharpened cutting edge.

Steps (iii) and (iv) of the process may, if desired, be repeated one or more times before step (v) is effected. This technique may, for example, be useful in producing dies where a cutting edge having the desired shape cannot immediately be obtained, or the cutting edge loses the desired shape during the steps preceding the second etching step (iv), or when a cutting edge having the desired shape is not obtained or the cutting edge loses the desired shape, for example as a result of unexpected circumstances affecting the process in the steps before the resist removal step (v). In this way a die having a cutting edge with the desired shape may eventually be formed.

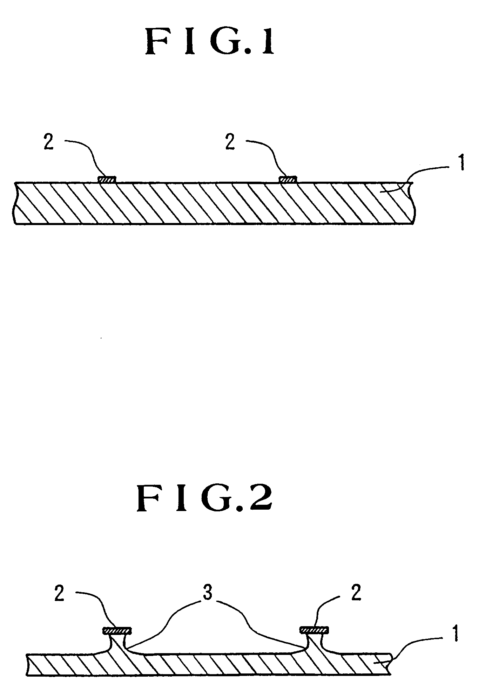

In the accompanying drawings, which serve to illustrate the invention without limiting it in any way, Figs. 1 to 4 represent cross-sections through a resist-carrying metal plate at successive stages in the preparation of a die in accordance with the invention. Fig. 5 represents a similar cross-section through a cutting edge of the final die.

A resist 2 having a pattern corresponding to the desired shape of a label is first formed on a metal plate 1 (Fig. 1). Metals may be used without any particular limitations, and include steels such as carbon steel, stainless steel and the like. The thickness of the plate 1 is similarly not limited, although it will be appreciated that when the die formed from the plate 1 is to be used by being fitted over a roller, the plate 1 desirably has appropriate flexibility; similarly, when the die is used as a flat base cutter, the plate 1 desirably has an appropriate stiffness. Alternatively or additionally when the die is used as a flat base cutter, it is possible to support and reinforce the plate 1 with a metallic plate or synthetic resin plate having an appropriate stiffness.

The resist 2 may be formed on the plate 1 by, for example, known film-forming methods. The width of the resist 2, which ultimately determines the width of the body of the cutting edge of the die, is usually 100-1000 µm, and may, for example, be selected according to the intended purpose of the die.

The plate 1 on which the resist 2 has been formed is thereafter subjected to etching treatment, thereby leading to formation of a raised portion 3 in the position where the resist 2 had been formed (Fig. 2). Etchants which may be used for this purpose include known etching agents such as ferric chloride, hydrochloric acid, nitric acid or mixtures thereof. The etching time employed may vary according to the etchant used, but is usually 10-120 minutes. The height of the raised portion formed by this etching treatment is usually 70-900 µm, particularly when the resist 2 has the above-specified width.

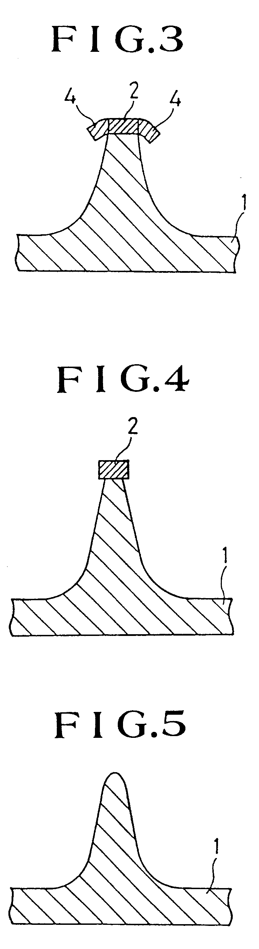

Next, the burr 4 of resist 2 extending beyond raised portion 3 is removed, for example by means of a grinder, router or the like. Thus, as shown in Fig. 3, the diagonal portions 4 of the resist 2 extending beyond the raised portion 3 are removed therefrom.

After the burr removal treatment the plate 1 is subjected to a further etching treatment, thereby modifying the raised portion (Fig. 4). According to the purpose for which the die is to be used, the burr removal and further etching treatments may be carried out several times. In general these treatments may be carried out 1 to 5 times, preferably 1 to 3 times, particular 1 or 2 times.

By effecting burr removal prior to the (or each) further etching treatment problems caused by uneven etching of the sides of the raised portion and/or decrease in the height of the resulting cutting edge, such as are encountered in conventional etching methods, may be substantially avoided. Thus it is possible to achieve substantially uniform etching of the sides of the raised portion, thereby producing a die in which the raised portion has sufficient height (e.g. 70-900 µm) and adequate width throughout this height.

After completion of this treatment, the desired die is obtained by carrying out a resist removal step consisting of removing the resist remaining on the raised portion 3 (e.g. by conventional methods known in the art) followed if necessary or desired by rinsing the plate 1.

After the resist removal step the plate 1 may if desired by subjected to a further etching treatment, for example to sharpen the tip of the cutting edge, to correct the width of the tip of the cutting edge when said width is excessively narrow (e.g. by reducing the height of the cutting edge), or to adjust the width of the tip portion of the cutting edge or the height of the cutting edge (e.g. so as to conform with a particular specification).

Etching after the (or each) burr removal step and optional etching after the resist removal step may, for example, be effected using one or more known etching agents, e.g. as hereinbefore described in connection with the initial etching step. Once again, the etching time employed may vary according to the etchant used, but is usually 0.5-50 minutes.

The novel dies obtainable in accordance with the process of the invention may be characterised by the following properties:-
(i) having a raised cutting portion of sufficient height;
(ii) having sufficient width throughout this height;
(iii) sharpness of tip at the cutting edge; and
(iv) durability, both as regards resistance to breakage and good wear properties.

The invention is further illustrated with respect to the following non-limitative Examples.

### Example 1

A resist 600 µm in width, in a pattern corresponding to the desired shape of a die, was formed in conventional manner on a carbon steel plate, and this plate was subjected to a first etching (spray pressure 0.8 kg/cm²) for 30 minutes with an etchant (ferric chloride, 30°C), leaving a raised portion 500 µm in height. The width of the top of the raised portion was 300 µm, and therefore there was a total excess resist of 300 µm extending beyond the raised portion. This was removed by means of a router. Thereafter, the plate was subjected to a second etching for 20 minutes under the same conditions as in the first etching, washed with water, and the resist on the top of the raised portion was removed, thereby producing a die in which the height of the cutting edge was 780 µm and the width of the top of the raised portion was 130 µm.

### Example 2

In the same manner as in Example 1, a resist 750 µm in width was formed on a carbon steel plate, and the plate was subjected to a first etching (spray pressure 0.8 kg/cm²) for 15 minutes with an etchant (ferric chloride, 30°C), leaving a raised portion 230 µm in height; the width of the top of the raised portion was 550 µm. The excess 200 µm of resist extending beyond the raised portion was removed by means of a router, whereafter the plate was subjected to a second etching for 10 minutes, in the same manner as Example 1. The height of the raised portion was then 400 µm and the width of its top was 350 µm.

The excess 200 µm of resist extending beyond the raised portion was again removed by means of a router and the plate was subjected for 5 minutes to further etching, again in the same manner as Example 1, whereafter the height of the raised portion was 470 µm and the width of its top was 100 µm. After removal of the resist from the top of the raised portion, the plate was etched as described in Example 1 for 1 minute, washed with water and dried. The resulting die had a height of 500 µm and a cutting edge which was round and sharp rather than trapezoidal.

### Comparative Example 1

On a hardened steel plate was formed a resist 500 µm in width in a pattern corresponding to the desired shape of a die, and the steel plate was subjected for 50 minutes to etching with an etchant (ferric chloride), thereby leaving a raised portion 400 µm in height. Subsequently, the resist remaining on the top of the raised portion was removed therefrom, the plate was subjected for 3 minutes to etching with an etchant (ferric chloride), followed by rinsing. The die thus obtained had a cutting edge of 380 µm in height at the highest, said cutting edge being dull and slender at the centre part of its cross-section.

## Claims

1. A process for producing a cutting die which comprises
(i) forming a resist material on a surface of a metal plate in a pattern corresponding to the shape to be cut by the die;
(ii) subjecting the resulting plate to an etching treatment such that a raised portion of metal remains where the resist material has been formed;
(iii) removing resist material which extends beyond the said raised portion;
(iv) subjecting the resulting plate to a further etching treatment; and
(v) removing the resist material from the raised portion.

2. A process as claimed in claim 1 wherein the metal plate is of steel.

3. A process as claimed in claim 1 or claim 2 wherein steps (iii) and (iv) are repeated at least once before step (v) is effected.

4. A process as claimed in any of claims 1 to 3 in which the die obtained from step (v) is subjected to a further etching step.

5. Cutting dies obtainable by a process as claimed in any of the preceding claims.

## Patentansprüche

1. Verfahren zur Herstellung eines Schnittwerkzeuges, umfassend
(i) Ausbilden eines Schutzmaterials auf einer Oberfläche einer Metallplatte in einem der durch das Schnittwerkzeug auszuschneidenden Form entsprechenden Muster;
(ii) Ätzbehandlung der resultierenden Platte, so daß dort, wo das Schutzmaterial ausgebildet worden ist, ein erhabener Bereich aus Metall zurückbleibt;
(iii) Entfernen von Schutzmaterial, das über den erhabenen Bereich hinausragt;
(iv) weitere Äztbehandlung der resultierenden Platte; und
(v) Entfernen des Schutzmaterials von dem erhabenen Bereich.

2. Verfahren wie in Anspruch 1 beansprucht, wobei die Metallplatte aus Stahl besteht.

3. Verfahren wie in Anspruch 1 oder Anspruch 2 beansprucht, wobei die Schritte (iii) und (iv) mindestens einmal wiederholt werden, bevor Schritt (v) ausgeführt wird.

4. Verfahren wie in irgendeinem der Ansprüche 1 bis 3 beansprucht, bei dem das aus Schritt (v) erhaltene Schnittwerkzeug einem weiteren Ätzschritt unterzogen wird.

5. Schnittwerkzeuge, die durch ein in irgendeinem der vorhergehenden Ansprüche beanspruchtes Verfahren erhalten werden können.

## Revendications

1. Procédé de fabrication d'une matrice de découpe qui comprend les étapes consistant à
(i) former un matériau de résist sur la surface d'une plaque de métal selon un motif correspondant à la forme que doit découper la matrice ;
(ii) soumettre la plaque résultante à un traitement de gravure tel qu'une partie de métal en saillie reste là où le matériau de résist a été formé ;
(iii) éliminer le matériau du résist qui s'étend au-delà de ladite partie en saillie ;
(iv) soumettre la plaque résultante à un traitement de gravure supplémentaire ; et
(v) éliminer le matériau de résist de la partie en saillie.

2. Procédé selon la revendication 1, dans lequel la plaque de métal est en acier.

3. Procédé selon la revendication 1 ou la revendication 2, dans lequel les étapes (iii) et (iv) sont répétées au moins une fois avant que l'étape (v) soit effectuée.

4. Procédé selon l'une quelconque des revendications 1 à 3, dans lequel la matrice obtenue à l'issue de l'étape (v) est soumise à une étape de gravure supplémentaire.

5. Matrices de découpe pouvant être obtenues par un procédé selon l'une quelconque des revendications précédentes.
